# EUROPEAN PATENT APPLICATION

(11) **EP 4 685 109 A1**
(43) Date of publication of application: **28.01.2026**
(21) Application number: 23924468.4
(22) Date of filing: 27.07.2023
(51) Int. Cl.: C01B 32/05, H01M 4/36, H01M 4/38, H01M 4/583, H01M 10/0525, B82Y 30/00

(54) **PLASMA MODIFICATION PREPARATION METHOD FOR SILICON-CARBON COMPOSITE MATERIAL, SILICON-CARBON COMPOSITE MATERIAL, AND USE**

(30) Priority: 27.06.2023 CN 202310773051
(71) Applicant: Shinghwa Advanced Material Technology (Meishan) Co., Ltd., Meishan, Sichuan 620010 (CN); Shinghwa Advanced Material Technology (Lianjiang) Co., Ltd., Fuzhou, Fujian 350512 (CN); Shida Shinghwa Advanced Material Group Co., Ltd., Dongying, Shandong 257503 (CN)
(72) Inventor: XING, Xianbo, Dongying, Shandong 257503 (CN); DING, Weitao, Dongying, Shandong 257503 (CN); LIU, Denghua, Dongying, Shandong 257503 (CN); GAO, Mingliang, Dongying, Shandong 257503 (CN); LIU, Dianzhong, Dongying, Shandong 257503 (CN); ZHANG, Zhiwei, Dongying, Shandong 257503 (CN)
(74) Representative: Kurig, Thomas
(86) International application number: PCT/CN2023/109699
(87) International publication number: WO 2025/000627

(57) **Abstract**

The present invention discloses a plasma modification preparation method of a silicon-carbon composite material, and a silicon-carbon composite material and a use thereof. The preparation method includes at least operation steps of: S10). placing aminated porous carbon in a deposition chamber, introducing a silane gas into the deposition chamber, and depositing nano-silicon in the aminated porous carbon, to obtain a silicon-carbon precursor material; S20). transferring the silicon-carbon precursor material to a plasma method modification chamber, introducing a halogen gas in a plasma manner, and depositing generated halide ions on a surface of the silicon-carbon precursor material, to obtain a silicon-carbon precursor material coated with halogenated carbon; and S30). stopping introducing the halogen gas, and introducing a carbon source gas in the plasma manner, to obtain the silicon-carbon composite material. The obtained silicon-carbon composite material has a stable core-shell structure, which can significantly alleviate silicon expansion problems and significantly improve cycle performance of a battery to which the silicon-carbon composite material is applied. In addition, the present application has a simple process, the silicon-carbon material is modified according to a plasma method, and the silicon-carbon composite material is easily prepared in batches and is easily industrialized on a scale.

## Description

The present application claims priority to Chinese Patent Application No. 2023107730517, filed with the China National Intellectual Property Administration on June 27, 2023 and entitled "PLASMA MODIFICATION PREPARATION METHOD OF SILICON-CARBON COMPOSITE MATERIAL, SILICON-CARBON COMPOSITE MATERIAL AND USE THEREOF", which is incorporated herein by reference in its entirety.

### TECHNICAL FIELD

The present invention belongs to the field of preparation of lithium ion battery materials, and specifically, relates to a plasma modification preparation method of a silicon-carbon composite material. The present invention further relates to a silicon-carbon composite material prepared according to the method and a use thereof.

### BACKGROUND

Silicon-carbon composite materials have advantages such as high-energy density and rich material resources, and therefore are widely applied to lithium ion batteries with high-energy density. A conventional preparation method of the silicon-carbon composite material mainly includes: depositing nano-silicon in porous carbon according to a silane pyrolysis method, and depositing and coating amorphous carbon at 700-1000°C according to a vapor phase deposition method. A carbon structure coated on an outer layer of the silicon-carbon composite material prepared according to the method is unstable, and an obvious silicon expansion problem occurs because silicon grains become larger at 700-1000°C. Consequently, cycle performance of a battery is obviously and negatively affected.

Therefore, the applicants hope to seek a technical solution to alleviate the above technical problems.

### SUMMARY OF INVENTION

In view of this, an objective of the present invention is to provide a plasma modification preparation method of a silicon-carbon composite material, and a silicon-carbon composite material and a use thereof. An obtained silicon-carbon composite material has a stable core-shell structure. Therefore, silicon expansion problems can be significantly alleviated, and cycle performance of a battery to which the silicon-carbon composite material is applied can be significantly improved. In addition, the preparation method provided in the present application has a simple process, the silicon-carbon material is modified according to a plasma method, and the silicon-carbon composite material is easily prepared in batches and is easily industrialized on a scale.

Technical solutions of the present invention are as follows:
A plasma modification preparation method of a silicon-carbon composite material is provided. The preparation method includes at least the following operation steps:
S10). placing aminated porous carbon in a deposition chamber, introducing a silane gas into the deposition chamber at a flow rate of 100-1000 ml/minute for at least 30 minutes at 400-600°C, and depositing nano-silicon in the aminated porous carbon, to obtain a silicon-carbon precursor material;
S20). transferring the silicon-carbon precursor material obtained in the step S10) to a plasma method modification chamber, introducing a halogen gas into the plasma method modification chamber in a plasma manner, and depositing generated halide ions on a surface of the silicon-carbon precursor material, to obtain a silicon-carbon precursor material coated with halogenated carbon; and
S30). stopping introducing the halogen gas, and introducing a carbon source gas into the plasma method modification chamber in the plasma manner, to obtain the silicon-carbon composite material.

Preferably, in the step S20), parameter setting of the plasma method modification chamber is that: a vacuum degree is 1-10 pa, a temperature is 300-600°C, and an output power of a plasma method is 500-1000 W; and/or a flow rate of the halogen gas is 100-500 sccm, and introduction duration is at least 10 minutes.

Preferably, in the step S30), parameter setting of the plasma method modification chamber is that: a vacuum degree is 1-10 pa, a temperature is 300-600°C, and an output power of a plasma method is 500-1000 W; and/or a flow rate of the carbon source gas is 100-500 sccm, and introduction duration is at least 10 minutes.

Preferably, a preparation method of the aminated porous carbon in the step S10) includes the following operation steps:
S11). pre-acidifying porous carbon by using concentrated nitric acid, to obtain acidified porous carbon;
S12). mixing the acidified porous carbon in the step S11) with sulfoxide chloride and N, N-dimethylformamide, and performing a reaction at 30-100°C for at least 1 hour, to obtain acyl-chlorinated porous carbon; and
S13). reacting the acyl-chlorinated porous carbon obtained in the step S12) with aniline to obtain amidated porous carbon, and using the amidated porous carbon as the aminated porous carbon.

Preferably, a preparation method of the aminated porous carbon includes the following operation steps:
S11). adding porous carbon to concentrated nitric acid, and performing heating and refluxing at 30-100°C for at least 1 hour, to obtain acidified porous carbon, where a mass ratio of the porous carbon to the concentrated nitric acid is 1:200-500;
S12). mixing the acidified porous carbon in the step S11) with sulfoxide chloride and N, N-dimethylformamide, and performing a reaction at 30°C-100°C for at least 1 hour, to obtain acyl-chlorinated porous carbon, where a mass ratio of the acidified porous carbon to the sulfoxide chloride to the N, N-dimethylformamide is 1:20-80:5-15; and
S13). reacting the acyl-chlorinated porous carbon obtained in the step S12) with aniline at 0-40°C for at least 1 hour to obtain amidated porous carbon, and using the amidated porous carbon as the aminated porous carbon, where a mass ratio of the acyl-chlorinated porous carbon to the aniline is 1:10-30.

Preferably, the step S12) is performed after the acidified porous carbon is washed with deionized water and dried in the step S11); and/or the step S13) is performed after the acyl-chlorinated porous carbon is washed with tetrahydrofuran and dried in the step S12); and/or the amidated porous carbon is washed with acetone to a colorless state in the step S13).

Preferably, the halogen gas in the step S20) is one or a mixture of several of a fluorine gas, a chlorine gas, or a bromine gas.

Preferably, the carbon source gas in the step S30) is one or a mixture of several of methane, ethylene, acetylene, or ethylene.

Preferably, a silicon-carbon composite material is provided. The silicon-carbon composite material is prepared according to the plasma modification preparation method of a silicon-carbon composite material described above, wherein the silicon-carbon composite material includes a core-shell structure including a core and a shell, the core includes a nitrogen-doped silicon-carbon composite material, and the shell includes halogenated carbon and amorphous carbon.

Preferably, a use of the foregoing silicon-carbon composite material is provided. The silicon-carbon composite material is used as an active substance raw material for preparing a battery electrode sheet, and is preferably used as an active substance raw material of a negative electrode sheet of a lithium-ion battery.

In the present invention, a chemical bond is formed by using amino on a surface of the amidated porous carbon and a silicon radical generated through pyrolysis of the silane gas, thereby improving stability of a core structure of the material, and improving cycle performance of a battery to which the material is applied. In the present invention, the plasma manner is further used to introduce the halogen gas into the silicon-carbon precursor material (as the core structure) to form the halogenated carbon coated on the surface of the silicon-carbon precursor material. Compared with a conventional vapor phase deposition method, according to the preparation method provided in the present invention, diffusion of the halide ions in the material can be facilitated, halogenation duration can be significantly shortened and a halogenation temperature can be reduced, and an impact on growth of silicon grains can be further reduced. In addition, in the present application, amorphous carbon located on a surface of the halogenated carbon is further formed in the plasma manner after the halogenated carbon is formed, then a shell structure including the halogenated carbon and the amorphous carbon is formed, and the shell structure together with the core structure of the material form a stable core-shell structure, thereby significantly alleviating silicon expansion problems, and significantly improving the cycle performance of the battery to which the material is applied. In addition, the preparation method provided in the present application has a simple process, the silicon-carbon material is modified according to a plasma method, and the silicon-carbon composite material is easily prepared in batches and is easily industrialized on a scale.

### DESCRIPTION OF DRAWINGS

FIG. 1 is a block diagram of preparation steps of a silicon-carbon composite material according to a specific implementation of the present invention; and
FIG. 2 shows an SEM graph of a silicon-carbon composite material prepared in Embodiment 1 of the present invention.

### DETAILED DESCRIPTION OF EMBODIMENTS

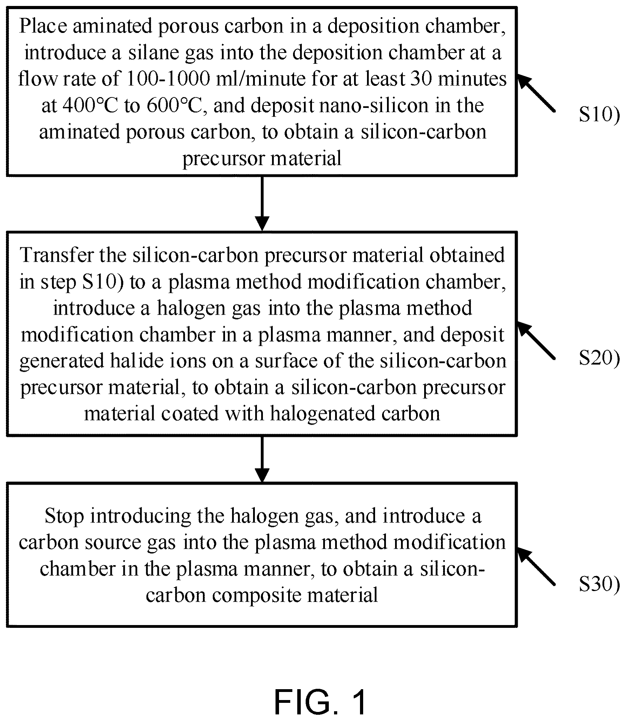

Refer to FIG. 1. Embodiments of the present invention provide a plasma modification preparation method of a silicon-carbon composite material. The preparation method includes at least the following operation steps:
S10). Place aminated porous carbon in a deposition chamber, introduce a silane gas (the silane gas is preferably a mixed gas of silane and an inert gas, where a volume ratio of the silane to the inert gas is 1:5-15, preferably, 1:8-12) into the deposition chamber at a flow rate of 100-1000 ml/minute for at least 30 minutes (preferably, 30-300 minutes) at 400-600°C, and deposit nano-silicon in the aminated porous carbon, to obtain a silicon-carbon precursor material;
S20). Transfer the silicon-carbon precursor material obtained in the step S10) to a plasma method modification chamber, introduce a halogen gas into the plasma method modification chamber in a plasma manner, and deposit generated halide ions on a surface of the silicon-carbon precursor material, to obtain a silicon-carbon precursor material coated with halogenated carbon. Preferably, to further facilitate coating and deposition effects of the halogenated carbon, in the step S20), parameter setting of the plasma method modification chamber is that: a vacuum degree is 1-10 pa, a temperature is 300-600°C, and an output power of a plasma method is 500-1000 W; and/or a flow rate of the halogen gas is 100-500 sccm, and introduction duration is at least 10 minutes, more preferably, 10-60 minutes. Preferably, the halogen gas in the step S20) is one or a mixture of several of a fluorine gas, a chlorine gas, or a bromine gas;
S30). Stop introducing the halogen gas, and introduce a carbon source gas into the plasma method modification chamber in the plasma manner, to obtain the silicon-carbon composite material. Preferably, to further facilitate coating and deposition effects of amorphous carbon, in the step S30), parameter setting of the plasma method modification chamber is that: a vacuum degree is 1-10 pa, a temperature is 300-600°C, and an output power of a plasma method is 500-1000 W; and/or a flow rate of the carbon source gas is 100-500 sccm, and introduction duration is at least 10 minutes, more preferably, 10-60 minutes. Preferably, the carbon source gas in the step S30) is one or a mixture of several of methane, ethylene, acetylene, or ethylene.

Preferably, a preparation method of the aminated porous carbon in the step S10) of this embodiment includes the following operation steps:
S11). Pre-acidify porous carbon by using concentrated nitric acid, to obtain acidified porous carbon;
S12). Mix the acidified porous carbon in the step S11) with sulfoxide chloride and N, N-dimethylformamide, and perform a reaction at 30-100°C for at least 1 hour, to obtain acyl-chlorinated porous carbon;
S13). React the acyl-chlorinated porous carbon obtained in the step S12) with aniline to obtain amidated porous carbon, and use the amidated porous carbon as the aminated porous carbon.

Further preferably, a preparation method of the aminated porous carbon in the step S10) of this embodiment includes the following operation steps:
S11). Add porous carbon to concentrated nitric acid, where a mass ratio of the porous carbon to the concentrated nitric acid is 1:200-500; and perform heating and refluxing at 30-100°C for at least 1 hour, to obtain acidified porous carbon, where duration for heating and refluxing is preferably 1-6 hours. Preferably, the step S12) is performed after deionized water washing, filtration, and vacuum drying are performed on the acidified porous carbon in the step S11);
S12). Mix the acidified porous carbon in the step S11) with sulfoxide chloride and N, N-dimethylformamide, and perform a reaction at 30-100°C for at least 1 hour, to obtain acyl-chlorinated porous carbon, where a mass ratio of the acidified porous carbon to the sulfoxide chloride to the N, N-dimethylformamide is 1:20-80:5-15. Preferably, the step S13 is performed after the acyl-chlorinated porous carbon is washed with tetrahydrofuran and dried in the step S12);
S13). React the acyl-chlorinated porous carbon obtained in the step S12) with aniline at 0-40°C for at least 1 hour, to obtain amidated porous carbon, and use the amidated porous carbon as the aminated porous carbon, where a mass ratio of the acyl-chlorinated porous carbon to the aniline is 1:10-30. Preferably, in the step S13), after the amidated porous carbon prepared through the reaction is washed with acetone to a colorless state, the washed amidated porous carbon is used as the aminated porous carbon in the step S10) of this embodiment.

Preferably, a silicon-carbon composite material is provided. The silicon-carbon composite material is prepared according to the plasma modification preparation method of a silicon-carbon composite material described above. The silicon-carbon composite material includes a core-shell structure including a core and a shell, the core includes a nitrogen-doped silicon-carbon composite material, and the shell includes halogenated carbon and amorphous carbon.

Preferably, a use of the foregoing silicon-carbon composite material is provided. The silicon-carbon composite material is used as an active substance raw material for preparing a battery electrode sheet, and is preferably used as an active substance raw material of a negative electrode sheet of a lithium-ion battery. Certainly, the silicon-carbon composite material may alternatively be used as required.

To enable a person skilled in the art to better understand the technical solutions in the present invention, the technical solutions in the embodiments of the present invention are clearly and completely described below with reference to the accompanying drawings in the embodiments of the present invention. Obviously, the described embodiments are merely some rather than all of the embodiments of the present invention. All other embodiments obtained by a person of ordinary skill in the art based on the embodiments of the present invention without creative efforts shall fall within the protection scope of the present invention.

Based on the foregoing described implementations, the present application further provides the following specific Embodiments 1-3:
It should be noted that aminated porous carbon prepared according to the following steps is used in the specific Embodiments 1-3:
S11). Add 10 g of porous carbon to 300 g of concentrated nitric acid, perform heating and refluxing at 80°C for 3 hours, perform deionized water washing and filtration after standing, and perform vacuum drying at 80°C for 24 hours, to obtain acidified porous carbon;
S12). Add 1 g of acidified porous carbon obtained in the step S11) to 60 g of sulfoxide chloride, add 10 g of N, N-dimethylformamide, perform a reaction at 80°C for 3 hours, and then perform tetrahydrofuran ("THF" for short) washing and drying, to obtain acyl-chlorinated porous carbon;
S13). React 1 g of acyl-chlorinated porous carbon obtained in step the S12) with 20 g of aniline at 20°C for 3 hours, then wash a reactant with acetone to colorless to obtain amidated porous carbon, and use the amidated porous carbon as aminated porous carbon.

**Embodiment** 1: A silicon-carbon composite material is prepared according to the following steps:
Step S10). Place 100 g of aminated porous carbon in a deposition chamber; first introduce a silane mixed gas (where a volume ratio of a silane gas to an argon gas is 1:10) into the deposition chamber, where a temperature of the deposition chamber is set to 500°C, a flow rate of the silane mixed gas is 50 ml/minute, and introduction duration is 90 minutes; and deposit nano-silicon in the aminated porous carbon to obtain a silicon-carbon precursor material;
Step S20): Transfer 100 g of silicon-carbon precursor material obtained in the step S10) to a plasma method modification chamber, and introduce a chlorine gas into the plasma method modification chamber in a plasma manner, where parameter setting of the plasma method modification chamber is that: a vacuum degree is 5 pa, a temperature is 400°C, and an output power of a plasma method is 800 W, and a flow rate of the chlorine gas is 300 sccm and introduction duration is 30 minutes; and deposit generated chloride ions on a surface of the silicon-carbon precursor material, to obtain a silicon-carbon precursor material coated with chlorinated carbon;
S30). Stop introducing the chlorine gas, and introduce a methane gas into the plasma method modification chamber in the plasma manner, to obtain a silicon-carbon composite material, where parameter setting of the plasma method modification chamber is that: a vacuum degree is 5 pa, a temperature is 400°C, and an output power of a plasma method is 800 W, and a flow rate of the methane gas is 300 sccm and introduction duration is 30 minutes.

The silicon-carbon composite material obtained in Embodiment 1 includes a core-shell structure including a core and a shell, where the core includes a nitrogen-doped silicon-carbon composite material, and the shell includes the chlorinated carbon and amorphous carbon coated on a surface of the chlorinated carbon.

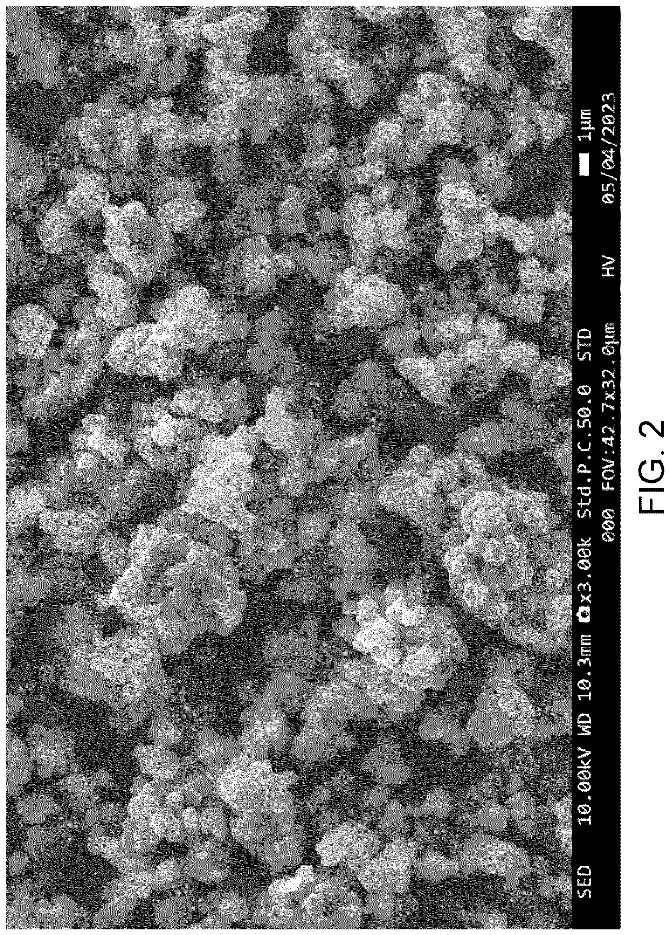

In the present application, an SEM test is performed on the silicon-carbon composite material prepared in Embodiment 1. For a test result, refer to FIG. 2. It can be learned from FIG. 2 that the silicon-carbon composite material provided in Embodiment 1 presents a spherical structure with uniform size and distribution and slightly bonded to each other, sizes and distribution of grains of the material are reasonable, and a grain size is between 1-5 µm.

**Embodiment 2:** A silicon-carbon composite material is prepared according to the following steps:
Step S10). Place 100 g of aminated porous carbon in a deposition chamber; first introduce a silane mixed gas (where a volume ratio of a silane gas to an argon gas is 1:10) into the deposition chamber, where a temperature of the deposition chamber is set to 400°C, a flow rate of the silane mixed gas is 10 ml/minute, and introduction duration is 300 minutes; and deposit nano-silicon in the aminated porous carbon to obtain a silicon-carbon precursor material;
Step S20): Transfer 100 g of silicon-carbon precursor material obtained in the step S10) to a plasma method modification chamber, and introduce a fluorine gas into the plasma method modification chamber in a plasma manner, where parameter setting of the plasma method modification chamber is that: a vacuum degree is 1 pa, a temperature is 300°C, and an output power of a plasma method is 500 W, and a flow rate of the fluorine gas is 100 sccm and introduction duration is 60 minutes; and deposit generated fluoride ions on a surface of the silicon-carbon precursor material, to obtain a silicon-carbon precursor material coated with fluorinated carbon;
S30). Stop introducing the fluorine gas, and introduce an ethylene gas into the plasma method modification chamber in the plasma manner, to obtain a silicon-carbon composite material, where parameter setting of the plasma method modification chamber is that: a vacuum degree is 1 pa, a temperature is 300°C, and an output power of a plasma method is 500 W, and a flow rate of the ethylene gas is 100 sccm and introduction duration is 60 minutes.

The silicon-carbon composite material obtained in Embodiment 2 includes a core-shell structure including a core and a shell, where the core includes a nitrogen-doped silicon-carbon composite material, and the shell includes the fluorinated carbon and amorphous carbon coated on a surface of the fluorinated carbon.

**Embodiment** 3: A silicon-carbon composite material is prepared according to the following steps:
Step S10). Place 100 g of aminated porous carbon in a deposition chamber; first introduce a silane mixed gas (where a volume ratio of a silane gas to an argon gas is 1:10) into the deposition chamber, where a temperature of the deposition chamber is set to 600°C, a flow rate of the silane mixed gas is 100 ml/minute, and introduction duration is 30 minutes; and deposit nano-silicon in the aminated porous carbon to obtain a silicon-carbon precursor material;
Step S20): Transfer 100 g of silicon-carbon precursor material obtained in the step S10) to a plasma method modification chamber, and introduce a bromine gas into the plasma method modification chamber in a plasma manner, where parameter setting of the plasma method modification chamber is that: a vacuum degree is 10 pa, a temperature is 600°C, and an output power of a plasma method is 1000 W, and a flow rate of the bromine gas is 500 sccm and introduction duration is 10 minutes; and deposit generated bromide ions on a surface of the silicon-carbon precursor material, to obtain a silicon-carbon precursor material coated with brominated carbon;
S30). Stop introducing the bromine gas, and introduce an acetylene gas into the plasma method modification chamber in the plasma manner, to obtain a silicon-carbon composite material, where parameter setting of the plasma method modification chamber is that: a vacuum degree is 10 pa, a temperature is 500°C, and an output power of a plasma method is 1000 W, and a flow rate of the acetylene gas is 500 sccm and introduction duration is 10 minutes.

The silicon-carbon composite material obtained in Embodiment 3 includes a core-shell structure including a core and a shell, where the core includes a nitrogen-doped silicon-carbon composite material, and the shell includes the brominated carbon and amorphous carbon coated on a surface of the brominated carbon.

**Comparative Example 1:** Remaining technical solutions of Comparative Example 1 are the same as those of Embodiment 1. A difference lies in that porous carbon (directly purchased) is used in Comparative Example 1 to replace the aminated porous carbon in Embodiment 1.

**Comparative Example 2:** Remaining technical solutions of Comparative Example 2 are the same as those of Embodiment 1. A difference lies in that step S20) is canceled in Comparative Example 2, and step S30) in Embodiment 1 is replaced with the following step:

S30). Transfer 100 g of silicon-carbon precursor material obtained in step S10) to a plasma method modification chamber, and introduce an ethylene gas into the plasma method modification chamber in a plasma manner, to obtain a silicon-carbon composite material, where parameter setting of the plasma method modification chamber is that: a vacuum degree is 1 pa, a temperature is 300°C, and an output power of a plasma method is 500 W, and a flow rate of the ethylene gas is 100 sccm and introduction duration is 60 minutes.

**Comparative Example 3:** A halogen-doped carbon-silicon nano-material disclosed in Embodiment 1 of CN105047894A is used, and a preparation method of the halogen-doped carbon-silicon nano-material is as follows: 10 g of silicon nano-particles and 10 g of carbon source are uniformly dispersed in 200 mL of ethanol solution, where a mol ratio of polyvinylidene fluoride to polyvinylidene chloride to polytetrafluoroethylene is 1:2:1. Ball milling is performed for 3 hours after uniform stirring, and an obtained product is dried in a dryer at 100°C for 12 h. Finally, carbonization is performed in a nitrogen atmosphere, heating is performed at a heating rate of 5°C/min to reach 800°C and the temperature is maintained for 2 h, and the halogen-doped carbon-silicon nano-material is obtained after cooling.

To compare and verify effects of the foregoing embodiments and comparative examples, in the present application, physical and chemical tests are performed on the composite materials obtained in Embodiments 1-3 and Comparative Examples 1-3:
(1) A specific surface area and tap density of each silicon-carbon composite material are tested according to the national standard GB/T 38823-2020 "Silicon-Carbon", conductivity of each silicon-carbon composite material is tested by using a four-probe tester, and a silicon grain of each silicon-carbon composite material is tested through XRD. For test results, refer to Table 1.

### (2) Button battery test:

The silicon-carbon composite materials corresponding to Embodiments 1-3 and Comparative Examples 1-3 each are used as a negative electrode material of a lithium ion battery to prepare a button battery according to the following method:
adding a binder, a conductive agent, and a solvent to each corresponding silicon-carbon composite material, performing stirring to prepare a slurry, coating the slurry on a copper foil, and drying and pressing the copper foil to obtain a negative electrode sheet, where the binder is LA132, the conductive agent is SP (conductive carbon black), the solvent is NMP, a dosage ratio of the silicon-carbon composite material to SP to LA132 to NMP is 95 g:1 g:4 g:220 mL, an electrolyte solution is a solution with LiPF₆ as an electrolyte and with a concentration of 1 mol/L, the solvent is a mixture of EC and DEC with a volume ratio of 1:1, a lithium metal sheet is a counter electrode, and a membrane is a polypropylene (PP) membrane.

Each button battery is assembled in a glovebox filled with an argon gas, and then an electrochemical performance test is performed. Specifically, the electrochemical performance test is performed by using a CT2001A battery tester of WUHAN LAND, a charging/discharging voltage range is 0.005 V to 2.0 V, and a charging/discharging rate is 0.1 C. For test results, refer to Table 1.

Full-charge expansion is further performed on the negative electrode sheet of the foregoing button battery. A specific test process is as follows: An electrode sheet test is performed on a rolled button battery to obtain a thickness D1 of the negative electrode sheet, a full-charge thickness D2 of the negative electrode sheet is analyzed when the button battery is fully charged to a 100% SOC, and an expansion rate is calculated (expansion rate = (D2-D1)/D*100%). For test results, refer to Table 1.

**Table 1**

| | Initial specific discharge capacity (mAh/g) | Initial efficiency (%) | Specific surface area (m2/g) | Tap density (g/cm3) | Powder conductivity (S/cm) | Full-charge expansion | Silicon grain (nm) |
|---|---|---|---|---|---|---|---|
| Embodiment 1 | 1898.4 | 91.5 | 6.6 | 0.94 | 0.35 | 55.9% | 2.8 |
| Embodiment 2 | 1891.4 | 91.2 | 6.2 | 0.91 | 0.32 | 57.3% | 2.5 |
| Embodiment 3 | 1818.9 | 90.3 | 7.1 | 0.99 | 0.30 | 58.8% | 2.9 |
| Comparative Example 1 | 1765.7 | 88.3 | 4.6 | 0.86 | 0.17 | 87.0% | 4.0 |
| Comparative Example 2 | 1695.6 | 87.8 | 4.2 | 0.83 | 0.09 | 90.3% | 4.2 |
| Comparative Example 3 | 2013.5 | 88.4 | 4.8 | 0.90 | 0.21 | 105.4% | 4.9 |

It can be learned from the data in Table 1 that performance of the silicon-carbon composite materials prepared in Embodiments 1-3 of the present application is significantly better than that of the silicon-carbon composite materials prepared in Comparative Examples 1-3 in terms of initial efficiency and full-charge expansion.

### (3) Pouch battery performance test:

The silicon-carbon composite materials corresponding to Embodiments 1-3 and Comparative Examples 1-3 each are doped with 90% artificial graphite, an obtained product is used as a negative electrode material (that is, a negative electrode sheet), and the negative electrode material, a positive electrode ternary material (LiNi_{1/3}Co_{1/3}Mn_{1/3}O₂), an electrolyte solution, and a membrane are assembled into a 5 Ah pouch battery, where the membrane is celegard 2400, and the electrolyte solution is a LiPF₆ solution (a solvent is a mixed solution of EC and DEC with a volume ratio of 1:1, and a concentration of LiPF₆ is 1.3 mol/L).

The following performance tests are performed on each pouch battery:
a. Electrolyte solution adsorption capability test: drawing up V mL of electrolyte solution by using a 1 mL burette, adding a drop of electrolyte solution on a surface of each negative electrode sheet, performing timing until the electrolyte solution is completely absorbed, recording a time t, and calculating an electrolyte solution adsorption speed S=V/t of each negative electrode sheet. For test results, refer to Table 2.
b. Electrolyte solution retention rate test: calculating a theoretical electrolyte solution absorption amount m1 of a corresponding negative electrode sheet based on a parameter of each negative electrode sheet, weighing a weight m2 of the negative electrode sheet, then placing the negative electrode sheet in the electrolyte solution to soak for 24 hours, weighing a weight m3 of the negative electrode sheet, calculating an electrolyte solution absorption amount m3-m2 of the negative electrode sheet, and performing calculation according to the following formula:
electrolyte solution retention rate = (m3-m2)*100%/ml. For test results, refer to Table 2.

**Table 2**

| | Electrolyte solution absorption speed (S) | Electrolyte solution retention rate |
|---|---|---|
| Embodiment 1 | 34 | 91.4% |
| Embodiment 2 | 41 | 90.1% |
| Embodiment 3 | 48 | 89.9% |
| Comparative Example 1 | 98 | 85.9% |
| Comparative Example 2 | 123 | 83.7% |
| Comparative Example 3 | 91 | 86.3% |

It can be learned from Table 2 that the electrolyte solution absorption and retention capabilities of the silicon-carbon composite materials provided in Embodiments 1-3 are better than those of the silicon-carbon composite materials provided in Comparative Examples 1-3.

c. Cycle performance test: performing a cycle performance test on each prepared pouch battery, where test conditions of the cycle performance test are that a charging/discharging voltage range is 2.5-4.2 V, a temperature is 25±3.0°C, a charging/discharging rate is 1.0 C/1.0 C, and a quantity of cycle times is 500. For test results, refer to Table 3.

**Table 3**

| | Initial capacity retention rate (%) | Capacity retention rate (%) after 500 cycles |
|---|---|---|
| Embodiment 1 | 100 | 92.2 |
| Embodiment 2 | 100 | 92.7 |
| Embodiment 3 | 100 | 91.3 |
| Comparative Example 1 | 100 | 87.4 |
| Comparative Example 2 | 100 | 86.1 |
| Comparative Example 3 | 100 | 83.5 |

It can be learned from Table 3 that cycle performance of the pouch lithium ion batteries made of the silicon-carbon composite materials provided in Embodiments 1-3 is obviously better than that of the pouch lithium ion batteries made of the silicon-carbon composite materials provided in Comparative Examples 1-3.

d. Rate capability test: performing a rate capability test on each prepared pouch battery, where test conditions of the rate capability test are that a charging/discharging voltage range is 2.5 -4.2 V, a temperature is 25±3.0°C, charging is performed at 1.0 C, 3.0 C, 5.0 C, and 10.0 C, and discharging is performed at 1.0 C. For test results, refer to Table 4.

**Table 4**

| Model | Rate | 1 C | 3 C | 5 C | 10 C |
|---|---|---|---|---|---|
| Embodiment 1 | Charging ratio (%) | 100 | 97.23 | 95.36 | 93.67 |
| | Constant-current ratio (%) | 97.14 | 94.72 | 91.86 | 87.24 |
| Embodiment 2 | Charging ratio (%) | 100 | 97.11 | 95.20 | 93.21 |
| | Constant-current ratio (%) | 97.01 | 94.03 | 91.23 | 86.96 |
| Embodiment 3 | Charging ratio (%) | 100 | 97.98 | 96.11 | 94.28 |
| | Constant-current ratio (%) | 97.89 | 95.12 | 92.21 | 88.45 |
| Comparative Example 1 | Charging ratio (%) | 100 | 94.84 | 88.21 | 78.23 |
| | Constant-current ratio (%) | 94.91 | 90.79 | 87.19 | 82.66 |
| Comparative Example 2 | Charging ratio (%) | 100 | 94.16 | 86.67 | 76.32 |
| | Constant-current ratio (%) | 93.14 | 89.27 | 86.04 | 79.05 |
| Comparative Example 3 | Charging ratio (%) | 100 | 93.64 | 87.24 | 77.26 |
| | Constant-current ratio (%) | 94.32 | 90.01 | 87.03 | 81.34 |

It can be learned from Table 4 that the rate capabilities of the pouch lithium ion batteries made of the silicon-carbon composite materials provided in Embodiments-3 are obviously better than those of the pouch lithium ion batteries made of the silicon-carbon composite materials provided in Comparative Examples 1-3, that is, charging duration of the pouch batteries made of the silicon-carbon composite materials provided in Embodiments 1-3 is shorter.

It will be clear to a person skilled in the art that the present invention is not limited to the details of the foregoing example embodiments, and the present invention can be implemented in other specific forms without departing from the spirit or essential features of the present invention. Therefore, the embodiments should be regarded in all respects as examples rather than as restrictive, and the scope of the present invention is defined by the appended claims rather than the foregoing descriptions. Therefore, all changes falling within the meanings and scope of equivalent elements of the claims are included in the present invention. Any reference numeral in the claims shall not be construed as limiting the claims.

In addition, it should be understood that, although this specification has been described with reference to implementations, not every implementation includes only one independent technical solution, and such description of this specification is by way of clarity only. A person skilled in the art should take this specification as a whole, and the technical solutions of the embodiments may be combined as appropriate to obtain other implementations that can be understood by a person skilled in the art.

## Claims

1. A plasma modification preparation method of a silicon-carbon composite material, **characterized in that**, comprising at least the following operation steps:
S10). placing aminated porous carbon in a deposition chamber, introducing a silane gas into the deposition chamber at a flow rate of 100-1000 ml/minute for at least 30 minutes at 400-600°C, and depositing nano-silicon in the aminated porous carbon, to obtain a silicon-carbon precursor material;
S20). transferring the silicon-carbon precursor material obtained in the step S10) to a plasma method modification chamber, introducing a halogen gas into the plasma method modification chamber in a plasma manner, and depositing generated halide ions on a surface of the silicon-carbon precursor material, to obtain a silicon-carbon precursor material coated with halogenated carbon; and
S30). stopping introducing the halogen gas, and introducing a carbon source gas into the plasma method modification chamber in the plasma manner, to obtain the silicon-carbon composite material.

2. The plasma modification preparation method of a silicon-carbon composite material according to claim 1, **characterized in that**, in the step S20), parameter setting of the plasma method modification chamber is that: a vacuum degree is 1-10 pa, a temperature is 300-600°C, and an output power of a plasma method is 500-1000 W; and/or a flow rate of the halogen gas is 100-500 sccm, and introduction duration is at least 10 minutes.

3. The plasma modification preparation method of a silicon-carbon composite material according to claim 1, **characterized in that**, in the step S30), parameter setting of the plasma method modification chamber is that: a vacuum degree is 1-10 pa, a temperature is 300-600°C, and an output power of a plasma method is 500-1000 W; and/or a flow rate of the carbon source gas is 100-500 sccm, and introduction duration is at least 10 minutes.

4. The plasma modification preparation method of a silicon-carbon composite material according to claim 1, **characterized in that**, a preparation method of the aminated porous carbon in the step S10) comprises the following operation steps:
S11). pre-acidifying porous carbon by using concentrated nitric acid, to obtain acidified porous carbon;
S12). mixing the acidified porous carbon in the step S11) with sulfoxide chloride and N, N-dimethylformamide, and performing a reaction at 30-100°C for at least 1 hour, to obtain acyl-chlorinated porous carbon; and
S13). reacting the acyl-chlorinated porous carbon obtained in the step S12) with aniline to obtain amidated porous carbon, and using the amidated porous carbon as the aminated porous carbon.

5. The plasma modification preparation method of a silicon-carbon composite material according to claim 1, **characterized in that**, a preparation method of the aminated porous carbon comprises the following operation steps:
S11). adding porous carbon to concentrated nitric acid, and performing heating and refluxing at 30-100°C for at least 1 hour, to obtain acidified porous carbon, wherein a mass ratio of the porous carbon to the concentrated nitric acid is 1:200-500;
S12). mixing the acidified porous carbon in the step S11) with sulfoxide chloride and N, N-dimethylformamide, and performing a reaction at 30-100°C for at least 1 hour, to obtain acyl-chlorinated porous carbon, wherein a mass ratio of the acidified porous carbon to the sulfoxide chloride to the N, N-dimethylformamide is 1:20-80:5-15; and
S13). reacting the acyl-chlorinated porous carbon obtained in the step S12) with aniline at 0-40°C for at least 1 hour to obtain amidated porous carbon, and using the amidated porous carbon as the aminated porous carbon, wherein a mass ratio of the acyl-chlorinated porous carbon to the aniline is 1:10-30.

6. The plasma modification preparation method of a silicon-carbon composite material according to claim 4 or 5, **characterized in that**, the step S12) is performed after the acidified porous carbon is washed with deionized water and dried in the step S11); and/or the step S13) is performed after the acyl-chlorinated porous carbon is washed with tetrahydrofuran and dried in the step S12); and/or the amidated porous carbon is washed with acetone to a colorless state in the step S13).

7. The plasma modification preparation method of a silicon-carbon composite material according to claim 1, **characterized in that**, the halogen gas in the step S20) is one or a mixture of several of a fluorine gas, a chlorine gas, or a bromine gas.

8. The plasma modification preparation method of a silicon-carbon composite material according to claim 1, **characterized in that**, the carbon source gas in the step S30) is one or a mixture of several of methane, ethylene, acetylene, or ethylene.

9. A silicon-carbon composite material, **characterized in that**, the silicon-carbon composite material is prepared according to the plasma modification preparation method of a silicon-carbon composite material according to any one of claims 1 to 8, the silicon-carbon composite material comprises a core-shell structure comprising a core and a shell, the core comprises a nitrogen-doped silicon-carbon composite material, and the shell comprises halogenated carbon and amorphous carbon.

10. A use of the silicon-carbon composite material according to claim 9, **characterized in that** the silicon-carbon composite material is used as an active substance raw material for preparing a battery electrode sheet, and is preferably used as an active substance raw material of a negative electrode sheet of a lithium-ion battery.
